# EUROPEAN PATENT SPECIFICATION

(11) **EP 3 358 592 B1**
(45) Date of publication and mention of the grant of the patent: **01.05.2019**
(21) Application number: 17154256.6
(22) Date of filing: 01.02.2017
(51) Int. Cl.: H01H 47/00, G01R 31/02, G05B 9/02, H02H 5/12, H02H 3/20

(54) **OUTPUT SIGNAL SWITCHING DEVICE (OSSD)**
AUSGANGSSIGNALSCHALTVORRICHTUNG (OSSD)
DISPOSITIF DE COMMUTATION DE SIGNAL DE SORTIE (OSSD)

(43) Date of publication of application: 08.08.2018
(73) Proprietor: SICK AG, 79183 Waldkirch/Breisgau (DE)
(72) Inventor: Phay, Victor Kok Heng, 507082 Singapur (SG); Gao, Gifei, 560350 Singapur (SG)
(74) Representative: Manitz Finsterwald Patent- und Rechtsanwaltspartnerschaft mbB

(56) References cited:
- US-A- 5 481 194
- US-A1- 2003 030 440
- US-A1- 2014 319 928
- US-A1- 2014 362 480
- US-A1- 2016 377 666

## Description

The present invention relates to an OSSD (Output Signal Switching Device or Output State Switching Device) in accordance with the preamble of claim 1.

OSSDs are used in safety applications, e.g. to monitor if a safety door is opened and a person has gained access to a possibly dangerous area in the vicinity of a machine. An OSSD can be arranged at the safety door, wherein the opening of the door is detected by the OSSD. Upon the detection of the open door, the OSSD can signal, via the first output terminal and the second output terminal, to a safety control system of the machine that the door has been opened. Particularly, the output terminals can be connected to the safety control system via separate electrical connections (e.g. separate wires). The safety control system can then stop the machine in order to avoid any possible danger for the person approaching the machine.

An OSSD in accordance with the preamble of claim 1 is known from US 2014/0362480 A1. US 2014/0319928 A1 teaches a safety switching device having a guard locking device, wherein the type of activation of the guard locking device is automatically detected. From US 2003/0030440 A1 a leakage current detection unit is known.

In order to fulfil high safety levels, OSSDs usually comprise at least one pair of redundant electric output terminals, wherein the first output terminal and the second output terminal are at a high level (e.g. 24 V), if no safety-relevant event has to be reported to the safety control system (e.g. the safety door is closed).

In case a safety relevant event has to be reported to the safety control system, the OSSD switches the first and second output terminal to a low level (e.g. 0 V / ground). This change in voltage is detected by the safety control system, wherein the safety control system then can shut down the controlled machine.

The redundant use of the first and second output terminal allows a safe transmission of information from the OSSD to the safety control system, even if one of the output terminals (or the wire connected thereto) is erroneously e.g. shorted to the high level. In that case the switching to the low level can be transmitted to the safety control system via the other output terminal.

In order to detect such faults on the safe outputs (i.e. the first and second output terminal), it is known to apply test pulses to the first and second output terminals. These test pulses can switch the output terminal to a low level for a few hundred micro-seconds. Usually, test pulses at the first output terminal and at the second output terminal are caused to occur at different times so as to test the first and second output terminal independently. By monitoring the test pulses e.g. unwanted connections of the output terminals to the high level (shorts to high) or unwanted electrical connections between the first and second output terminals (cross-shorts) can be detected, e.g. by a controller or micro-controller unit (MCU) of the OSSD.

However, the use of test pulses involves high firmware efforts to generate the very short test pulses. If two different MCUs are used for the first and second output terminal, these MCUs have to be synchronized. Also, a high effort is required to monitor a read-back voltage level during the short test pulse period.

In order to generate the narrow test pulses, usually a low-side switch on an output stage connected to the first and/or second output terminal is required to switch the first and/or second output terminal to a low level (e.g. ground). Consequently, a dead time of the low-side switch has to be considered when switching a respective high-side switch used to switch the first and/or second output terminal to a high level. Furthermore, due to the test pulses, the resistive and capacitive loads connected to the output terminals must be limited. If the resistive and capacitive loads are not limited, the test pulses can be distorted due to RC effects which can lead to the erroneous detection of output faults.

In view of the foregoing it is an object of the present invention to provide an Output Signal Switching Device (OSSD) which is able to detect output faults with reduced effort and with reduced drawbacks.

This object is satisfied by an OSSD having the features of claim 1.

In accordance with the invention an Output Signal Switching Device (OSSD) is disclosed. The OSSD has
- at least one pair of electric output terminals, the pair of electric output terminals comprises a first output terminal and a second output terminal,
- first voltage reducing means, preferably connected to a supply voltage, that are adapted to reduce the supply voltage to a first voltage which is lower in magnitude than the supply voltage, second voltage reducing means, preferably connected to the supply voltage, that are adapted to reduce the supply voltage to a second voltage which is lower in magnitude than the first voltage,
- the second voltage is applied to the first output terminal and the first voltage is applied to the second output terminal, wherein switching means are provided which are adapted to provide at least one, preferably all of the following functions: to separate the second voltage from the first output terminal and/or the first voltage from the second output terminal, if the magnitude of the voltage at the second output terminal is equal to or higher than the magnitude of the supply voltage and/or if the magnitude of the voltage at the first output terminal is equal to or higher than the magnitude of the first voltage.

The invention is based on the finding that the use of three different voltages (i.e. the supply voltage, the first voltage and the second voltage) allows an easy comparison of these voltages. Consequently, if e.g. one of the output terminals is shorted to high, i.e. one of the output terminals is erroneously connected to e.g. the supply voltage, the voltage at the first or second output terminal becomes higher than expected. This increase of voltage at the output terminals can be detected. In case such an increase is detected, the first and/or second output terminals are switched off (i.e. switched to a low level or ground). Thereby a safety control system that can be connected to the first and second output terminals is informed of a problem with the OSSD as it recognizes that the first and/or second output terminal is switched to a low level.

In other words, the invention deliberately uses voltages for the first and second output terminal which are lower than the supply voltage and which can be lower as a nominal voltage defined in a standard applicable to the OSSD. This is possible since the used standards define ranges of voltages in which a signal is identified as on a high level.

For example, the supply voltage can be 24 V, preferably DC (direct current), whereas the first voltage can be 23 V and the second voltage can be 22 V. In general, the difference between the supply voltage and the first voltage can be the same as between the first voltage and the second voltage.

It is not necessary that the first voltage and the second voltage are lower than the supply voltage in absolute terms. If the supply voltage is negative (e.g. -24 V), the magnitude of the first voltage (|V₁|) and the magnitude of the second voltage (|V₂|) are lower than the magnitude of the supply voltage (|V_{supply}|). Thus, the first voltage can be -23 V, whereas the second voltage can be -22 V. In this case, if e.g. the magnitude of the first voltage increases from 23 V to 24 V (i.e. the first voltage changes from -23 V to -24 V), at least one of the output terminals can be switched to a low level.

The terms low level and high level shall be understood in the following as "a voltage of low magnitude" and as "a voltage of high magnitude (as compared to the low level)", respectively. For the sake of simplicity, the following explanations will assume that the supply voltage is a positive voltage. Thus, the switching means can be adapted to separate the second voltage from the first output terminal and/or the first voltage from the second output terminal, if the voltage at the second output terminal is equal to or higher than the supply voltage and/or if the voltage at the first output terminal is equal to or higher than the first voltage.

It is further to be understood that with respect to the first output terminal and the second output terminal the nomenclature or names of the output terminals could be exchanged.

Due to the use of different voltages in accordance with the invention, the use of test pulses can be omitted, which allows the complexity of the OSSD to be significantly reduced. Consequently, the OSSD of the invention can be produced with simpler components and can therefore be manufactured in a cost-effective way. Furthermore, the firmware complexity of the OSSD can also be significantly reduced as there is no need to generate and monitor test pulses. Likewise, as no test pulses are used, fewer restrictions are imposed on resistive and capacitive loads thus widening the application scope of the OSSD.

To put it short, the invention provides an OSSD that provides the supply voltage, the first voltage and the second voltage, wherein the first voltage is applied to the second output terminal and the second voltage is supplied to the first output terminal. The supply voltage, the first voltage and the second voltage are all different from each other in their initial voltage. At least one of the output terminals is switched off, if the voltage at the first and/or the voltage at the second output terminal differ from its respective initial voltage by more than a threshold value.

The OSSD of the invention can be adapted to fulfil the requirements of the Safety Integrity Level 3 (SIL3).

For example, the first voltage reducing means are preferably connected to a supply voltage and are adapted to reduce the supply voltage to the first voltage which is lower than the supply voltage. The second voltage reducing means are preferably connected to the supply voltage and are adapted to reduce the supply voltage to the second voltage which is lower than the first voltage. The first voltage reducing means can comprise one diode, whereas the second voltage reducing means can comprise two diodes disposed in series.

Advantageously the switching means are adapted to separate the second voltage from the first output terminal, if the magnitude of the voltage at the second output terminal is equal to or higher than the magnitude of the supply voltage. Additionally, the switching means can be adapted to separate the first voltage from the second output terminal, if the magnitude of the voltage at the first output terminal is equal to or higher than the magnitude of the first voltage. In other words, one output terminal is switched off (i.e. separated from the first or second voltage), if the voltage at the other output terminal is higher than expected. Thereby, a connected safety control system can be informed about a problem at the OSSD using the "correctly working" output terminal at which the voltage is not higher than expected.

Instead of comparing the magnitude of the voltages at the output terminals, the supply voltage, the first voltage and the second voltage, the absolute values (i.e. taking into account a leading sign) of these voltages can be compared.

For example, if the second output terminal is shorted to the supply voltage, then the voltage at the second output terminal is equal to the supply voltage. Even if the first voltage is then separated from the second output terminal, the second output terminal would not be pulled to a low level as it is shorted to the supply voltage. Hence, it is not possible to transmit a low level signal to the safety control system via the second output terminal. Therefore, the second voltage is separated from the first output terminal in order to transmit a low level signal to the safety control system.

The output terminals can be connected to a low level/low potential or ground via a diode and/or a resistor. Thereby, the output terminals are on a defined potential (e.g. ground) if the first and/or second voltage is separated from the respective output terminal.

Preferably, the switching means comprise a first breaker switch adapted to disconnect the second voltage from the first output terminal, if the magnitude of the voltage at the second output terminal is equal to or higher than the magnitude of the supply voltage. Additionally the switching means can comprise a second breaker switch adapted to disconnect the first voltage from the second output terminal, if the magnitude of the voltage at the first output terminal is equal to or higher than the magnitude of the first voltage. The first and second breaker switch can e.g. comprise a pnp-transistor or a MOSFET (Metal Oxide Semiconductor Field Effect Transistor). The first and/or second breaker switch can comprise a pnp-transistor or a MOSFET. The first breaker switch is preferably adapted to disconnect the second voltage reducing means from the first output terminal. Correspondingly, the second breaker switch is preferably adapted to disconnect the first voltage reducing means from the second ouput terminal.

Advantageously the first breaker switch is controlled by first comparing means which preferably are adapted to provide a first control signal to the first breaker switch, wherein the first control signal is preferably switched to inactive, if the first breaker switch is to disconnect the second voltage from the first output terminal. The second breaker switch can be controlled by second comparing means which preferably are adapted to provide a second control signal to the second breaker switch, wherein the second control signal is preferably switched to inactive if the second breaker switch is to disconnect the first voltage from the second output terminal.

Particularly, the first comparing means can be connected to the supply voltage and the second output terminal, wherein the first comparing means are adapted to switch the first control signal to inactive, if the voltage at the second output terminal becomes/is equal to or higher than the supply voltage. Correspondingly, the second comparing means can be connected to the voltage at the first output terminal and the first voltage. The second comparing means can be adapted to switch the second control signal to inactive, if the voltage at the first output terminal becomes/is equal to or higher than the first voltage.

For additional safety, the first and second control signal can be active, as long as the first and second breaker switches shall maintain a connection of the second voltage with the first output terminal and of the first voltage with the second output terminal. Particularly, the first breaker switch is disposed between the second voltage reducing means and the first output terminal. The second breaker switch can be disposed between the first voltage reducing means and the second output terminal.

Preferably the first comparing means comprise a first pnp-transistor, wherein the emitter of the first pnp-transistor is (directly) connected to the supply voltage and the base of the first pnp-transistor is (directly) connected to the second output terminal. Additionally the second comparing means can comprise a second pnp-transistor, wherein the emitter of the second pnp-transistor is (directly) connected to the first voltage and the base of the second pnp-transistor is (directly) connected to the first output terminal. The collector of the first pnp-transistor can produce the first control signal. The collector of the second pnp-transistor can produce the second control signal. During "normal" operation (i.e. when the voltage at the second output terminal is lower than the supply voltage and the voltage at the first output terminal is lower than the first voltage) the voltage at the respective emitter is higher than at the respective base of the pnp-transistor. This results in a current flowing out of the collector (i.e. the respective control signal is active). In a fault condition (i.e. if the first voltage is equal to or higher than the supply voltage and/or if the second voltage is equal to or higher than the first voltage) the voltage at the base of the respective pnp-transistor is equal to or higher than at the emitter leading to the switching off of the transistor. Thus, no current is produced by the collector, resulting in an inactive control signal. The inactive control signal leads to a switching off of the respective output terminal (i.e. the respective output terminal is switched to a low level). Using the described circuitry based on the pnp-transistors allows a very simply but reliable and fast switching off of the output terminals in fault conditions.

The pnp-transistors can be replaced by different switching means, e.g. by MOSFETs.

Advantageously a first high-side switch connected in series between the first voltage reducing means and the first breaker switch and/or a second high-side switch connected in series between the second voltage reducing means and the second breaker switch is comprised in the OSSD. The first and second high-side switches can be controlled independent of the breaker switches and the comparing means. The high-side switches can be adapted to selectively connect the respective voltage reducing means in series with the respective breaker switch or the respective output terminal. The high-side switches can be used to switch the output terminals to a low level independent of a recognized short to the supply voltage of one of the output terminals.

Preferably, the device comprises a controller which is adapted to receive the first control signal and/or the second control signal and to monitor the voltage at the first output terminal and/or at the second output terminal, wherein the controller is configured to switch off the first and/or second high-side switch, if the magnitude of the voltage at the second output terminal is equal to or higher than the magnitude of the supply voltage and/or if the magnitude of the voltage at the first output terminal is equal to or higher than the magnitude of the first voltage. In other words, the controller preferably controls the status of the high-side switches. The controller can be a micro-controller unit (MCU). The controller can be adapted to control the operation of the OSSD. For example, the controller can activate an (optical) warning signal in case of failure or fault. The controller can be adapted to save error codes that correspond to errors/faults recognized by the controller. Additionally, the controller may allow the use of a lock-out state.

The controller can comprise two separate controller units (e.g. separate MCUs), in order to provide a redundancy.

Additionally or alternatively to monitoring the voltage at the first output terminal and/or the second output terminal, the voltage at the first output terminal can be transformed into a first feedback signal and/or the voltage at the second output terminal can be transformed into a second feedback signal. The feedback signals can be inverted with respect to the voltage at the respective output terminal. The first and second feedback signals can be monitored by the controller. The monitored signals (e.g. the feedback signals) may be connected at least in part to interrupt pins of the controller in order to allow a fast response of the controller.

The controller therefore can have information about the status of the first and second high-side switch, the voltage at the first and second output terminal, the state of the first and second feedback signal and the first and second control signal. By combining this information, the controller can differentiate between possible faults, e.g. between shorts to high, shorts to low and/or cross-shorts. Particularly, different faults can generate different patterns of active/inactive signals that can be recognized.

For example, if no fault is present and the first and second high-side switches are both switched on (i.e. are in a conductive state), the first and second output terminals are at a high level (i.e. a high voltage, e.g. 22 Volt or 23 Volt). The output terminals at the high level cause the first and second control signal to be active. From these signals, the controller can deduce that no fault is present.

However, if e.g. the first output terminal is shorted to high (24 Volt), while the first and second high-side switches are switched on, the first output terminal is still at a high level but the second control signal is switched to inactive, whereas the first control signal remains active. The inactive second control signal leads to a switching off of the second output terminal. From the second control signal being inactive and the second output terminal being at a low level, in combination with the status of the further signals provided to the controller, the controller can deduce that the first output terminal is shorted to high.

In the same manner, if e.g. the second output terminal is shorted to high, while the high-side switches are switched off, the second output terminal is at a high level. The controller can then recognize that the second output terminal is at a high level when it should be at a low level. Thereby, the controller can derive that the second output terminal is shorted to high.

If a short to low of the first output terminal is present, while the high-side switches are switched on, the controller can detect from the low level (i.e. the low voltage, e.g. 0 Volt) at the first output terminal or from the first feedback signal that a fault is present. Specifically, the controller can deduce that a short to low is present, as the first output terminal is at a low level when it should be at a high level.

Similarly, a cross short can be detected, e.g. if the second control signal is inactive when it should be active.

The controller is thus able to differentiate between different faults.

Advantageously the device comprises at least one safety sensor, e.g. a magnetic door sensor, wherein the device is configured to separate the second voltage from the first output terminal and/or the first voltage from the second output terminal, if an activation of the safety sensor is detected. In case an activation of the safety sensor is detected, the high-side switches can be switched off in order to separate the second voltage from the first output terminal and/or the first voltage from the second output terminal. Apart from a magnetic door sensor, a light curtain and/or an emergency-stop switch could be used as safety sensor. An activation of the safety sensor can occur, if e.g. a door is opened and a magnet (i.e. a target) of the magnetic door sensor is moved away from the safety sensor as the door is opened (i.e. the target is not present anymore). In that case the safety control system has to be informed about a possible danger. Consequently, the first and/or second output terminal is switched to a low level.

Preferably, the security sensor directly switches off the high-side switches so as to separate the second voltage from the first output terminal and the first voltage from the second output terminal.

The invention also relates to a machine comprising at least one Output Signal Switching Device as described above. The machine further comprises a safety control system and working means, wherein the first output terminal and the second output terminal of the Output Signal Switching Device are independently electrically connected to the safety control system, wherein the safety control system shuts down the working means, if the magnitude of a voltage at the first and/or second output terminal falls below a predetermined threshold.

In other words, the first and second output terminals of the Output Signal Switching Device are (directly) electrically connected to the safety control system by two independent electrical connections, e.g. two independent electric wires.

The working means of the machine can e.g. be a hydraulic press, a robot, a saw and the like. If the Output Signal Switching Device e.g. detects that a security sensor is activated, the second voltage is separated from the first output terminal and/or the first voltage is separated from the second output terminal, resulting in a drop of the voltage at the first and/or second output terminal below the predetermined threshold (e.g. below 11 Volt). This results in the shut-down of the working means by the safety control system, in order not to endanger a person that e.g. approaches the machine.

The invention further relates to a method for operating an Output Signal Switching Device (OSSD) in accordance with claim 10.

The advantages and embodiments described above with respect to the inventive Output Signal Switching Device also apply to the inventive machine and to the inventive method.

Various features and advantages of the present invention will become more apparent from the following description and accompanying drawing wherein:

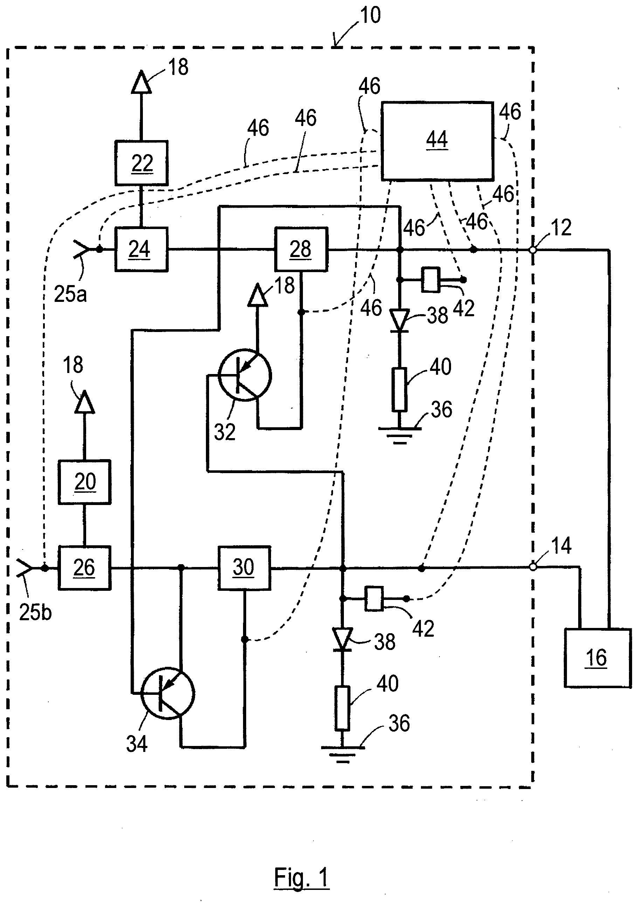

- Fig. 1: shows an Output Signal Switching Device.

Fig. 1 shows an Output Signal Switching Device (OSSD) 10. The OSSD 10 comprises a first output terminal 12 and a second output terminal 14. The first and second output terminals 12, 14 are each independently electrically connected to a safety control system 16. The safety control system 16 is e.g. connected to a manufacturing robot (not shown). If the safety control system 16 receives a low level signal from either the first output terminal 12 or the second output terminal 14, the safety control system 16 shuts down the manufacturing robot.

Within the OSSD 10 a supply voltage 18 is provided. The supply voltage 18 is applied to a first voltage reducing means 20 and to a second voltage reducing means 22. The supply voltage 18 can be 24 V. The first voltage reducing means 20 can reduce the supply voltage 18 by 1 V, e.g. by means of one diode (not shown). The second voltage reducing means 22 can reduce the supply voltage 18 by about 2 V, e.g. by means of two diodes (not shown) disposed in series. The reduced supply voltage is outputted by the first voltage reducing means 20 as a first voltage, whereas the reduced supply voltage is outputted by the second voltage reducing means 22 as a second voltage.

The second voltage can be switched through by a first high-side switch 24, whereas the first voltage can be switched through by a second high-side switch 26. The high-side switches 24, 26 can e.g. be formed by a pnp-transistor or a MOSFET.

The first high-side switch 24 is disposed in series between the second voltage reducing means 22 and a first breaker switch 28. Correspondingly, the second high-side switch 26 is disposed in series between the first voltage reducing means 20 and a second breaker switch 30. The first and second high-side switches 24, 26 can be controlled via a first input signal 25a and a second input signal 25b, respectively.

If both the first high-side switch 24 and the first breaker switch 28 are switched on (i.e. are in a conductive state) the second voltage provided by the second voltage reducing means 22 is applied to the first output terminal 12. Correspondingly, if the second high-side switch 26 and the second breaker switch 30 are switched on, the first voltage provided by the first voltage reducing means 20 is applied to the second output terminal 14.

A first pnp-transistor 32 is disposed such that its emitter is directly connected to the supply voltage 18. The base of the first pnp-transistor 32 is directly connected to an output of the second breaker switch 30, so that the voltage at the second output terminal 14 is applied to the base of the first pnp-transistor 32. The collector of the first pnp-transistor 32 is connected with the first breaker switch 28, wherein the first breaker switch 28 is switched on, if a current is flowing from the collector of the first pnp-transistor 32 to the first breaker switch 28.

A second pnp-transistor 34 is disposed such that its emitter is directly connected to the first voltage that is outputted by the second high-side switch 26 and inputted into the second breaker switch 30. The base of the second pnp-transistor 34 is directly connected to an output of the first breaker switch 28. The base is thus directly connected to the voltage of the first output terminal 12. The collector of the second pnp-transistor is connected with the second breaker switch 30, wherein the second breaker switch 30 is switched on, if a current is flowing out of the collector of the second pnp-transistor 34.

The first and second pnp-transistors 32, 34 act as comparing means.

The current between the first pnp-transistor 32 and the first breaker switch 28 acts as a first control signal for the first breaker switch 28. Correspondingly, the current between the second pnp-transistor 34 and the second breaker switch 30 acts as a second control signal which controls the second breaker switch 30.

The first and second output terminals 12, 14 are each connected to ground 36 via a diode 38 and a resistor 40 which are disposed in series. Both the first and second output terminals 12, 14 are also each connected to an inverter 42 which inverts the potential at the first or second output terminal 12, 14 and at the same time reduces the potential/voltage of the first and second output terminal 12, 14.

The OSSD 10 comprises a micro-controller unit (MCU) 44. The MCU 44 is connected to the first and second input signal 25a, 25b, to the first and second control signal, to the voltages present at the first and second output terminal 12, 14 and to the outputs of the inverters 42 via measurement lines 46.

The MCU 44 is able to detect different fault conditions based on a specific combination of the voltages at the different measurement lines 46.

During "normal" operation, the high-side switches 24, 26 and the breaker switches 28, 30 are in a conductive state. Consequently, the first voltage is present at the second output terminal 14, whereas the second voltage is present at the first output terminal 12. As the first voltage is lower than the supply voltage 18 but higher than the second voltage, the first and second pnp-transistors 32, 34 are both in a conductive state, which results in a current flowing out of the collector of the respective pnp-transistor 32, 34. These currents keep the breaker switches 28, 30 switched on.

In case the first output terminal 12 is shorted to the supply voltage 18, the voltage at the base of the second pnp-transistor 34 becomes 24 V, i.e. higher than the first voltage at the emitter of the second pnp-transistor 34 which leads the second pnp-transistor 34 to be switched off. Following the switch-off of the second pnp-transistor 34 the second breaker switch 30 is switched off, which leads the second output terminal 14 to being pulled to a low level, e.g. ground 36. By the low level of the second output terminal 14, the safety control system 16 is informed of an error/fault. The safety control system 16 then can switch off the manufacturing robot.

Correspondingly, if the second output terminal 14 is shorted to the supply voltage 18, the voltage at the base of the first pnp-transistor 32 becomes equal to the supply voltage and equal to the voltage applied to the emitter of the first pnp-transistor 32. This leads the first pnp-transistor 32 to switch off, wherein also the first breaker switch 28 is then switched off, due to a missing current from the collector of the first pnp-transistor 32. This causes the first output terminal 12 to be pulled to a low level (ground 36).

If a cross-short occurs, i.e. the first output terminal 12 is directly connected to the second output terminal 14, the voltages at the base and at the emitter of the second pnp-transistor 34 become the same, leading to the switch off of the second pnp-transistor 34 and therewith to the switch off of the second breaker switch 30.

Thereby, a reliable and fast detection of faults can be achieved, wherein faults result in an automatic notification to the safety control system 16 via a low level at at least one of the output terminals 12, 14.

### List of reference numerals

- 10: OSSD
- 12: first output terminal
- 14: second output terminal
- 16: safety control system
- 18: supply voltage
- 20: first voltage reducing means
- 22: second voltage reducing means
- 24: first high-side switch
- 25a: first input signal
- 25b: second input signal
- 26: second high-side switch
- 28: first breaker switch
- 30: second breaker switch
- 32: first pnp-transistor
- 34: second pnp-transistor
- 36: ground
- 38: diode
- 40: resistor
- 42: inverter
- 44: MCU
- 46: measurement lines

## Claims

1. An Output Signal Switching Device (OSSD) (10) having
- at least one pair of electric output terminals, the pair of electric output terminals comprising a first output terminal (12) and a second output terminal (14),
- first voltage reducing means (20) providing a first voltage which is lower in magnitude than the supply voltage (18),
- second voltage reducing means (22) providing a second voltage which is lower in magnitude than the first voltage,
**characterized in that**
the second voltage is applied to the first output terminal (12) and
the first voltage is applied to the second output terminal (14),
wherein
switching means (28, 30) are provided which are adapted
to separate the second voltage from the first output terminal (12) and/or the first voltage from the second output terminal (14), if the magnitude of the voltage at the second output terminal (14) is equal to or higher than the magnitude of the supply voltage (18) and/or if the magnitude of the voltage at the first output terminal (12) is equal to or higher than the magnitude of the first voltage.

2. The device (10) of claim 1, wherein
the switching means (28, 30) are adapted
to separate the second voltage from the first output terminal (12), if the magnitude of the voltage at the second output terminal (14) is equal to or higher than the magnitude of the supply voltage (18) and
to separate the first voltage from the second output terminal (14), if the magnitude of the voltage at the first output terminal (12) is equal to or higher than the magnitude of the first voltage.

3. The device (10) of claim 1 or 2, wherein
the switching means comprise
a first breaker switch (28) adapted to disconnect the second voltage from the first output terminal (12), if the magnitude of the voltage at the second output terminal (14) is equal to or higher than the magnitude of the supply voltage (18) and/or
a second breaker switch (30) adapted to disconnect the first voltage from the second output terminal (14), if the magnitude of the voltage at the first output terminal (12) is equal to or higher than the magnitude of the first voltage.

4. The device (10) of claim 3, wherein
the first breaker switch (28) is controlled by first comparing means (32) which preferably are adapted to provide a first control signal to the first breaker switch (28), wherein the first control signal is switched to inactive, if the first breaker switch is to disconnect the second voltage from the first output terminal (12), and/or
the second breaker switch (30) is controlled by second comparing means (34) which preferably are adapted to provide a second control signal to the second breaker switch (30), wherein the second control signal is switched to inactive, if the second breaker switch (30) is to disconnect the second voltage from the first output terminal.

5. The device (10) of claim 4, wherein
the first comparing means comprise a first pnp-transistor (28), wherein the emitter of the first pnp-transistor (28) is connected to the supply voltage and the base of the first pnp-transistor (28) is connected to the second output terminal (14), and/or
the second comparing means comprise a second pnp-transistor (30), wherein the emitter of the second pnp-transistor (30) is connected to the first voltage and the base of the second pnp-transistor (30) is connected to the first output terminal (12).

6. The device (10) of at least one of claims 3 to 5, further comprising
a first high-side switch (24) connected in series between the first voltage reducing means (20) and the first breaker switch (28) and/or
a second high-side switch (26) connected in series between the second voltage reducing means (22) and the second breaker switch (30).

7. The device (10) of at least claims 4 and 6, further comprising
a controller (44) which is adapted
to receive the first control signal and/or the second control signal and
to monitor the voltage at the first output terminal (12) and/or the second output terminal (14),
wherein the controller (44) is configured to switch off the first and/or the second high-side switch (24, 26), if the magnitude of the voltage at the second output terminal (14) is equal to or higher than the magnitude of the supply voltage (18) and/or if the magnitude of the voltage at the first output terminal (12) is equal to or higher than the magnitude of the first voltage.

8. The device (10) of at least one of the previous claims, further comprising
at least one safety sensor, e.g. a magnetic door sensor, wherein the device (10) is configured to separate the second voltage from the first output terminal (12) and/or the first voltage from the second output terminal (14), if an activation of the safety sensor is detected.

9. A machine comprising at least one output signal switching device (10) in accordance with at least one of the previous claims, a safety control system (16) and working means, wherein
the first output terminal (12) and the second output terminal (14) of the output signal switching device (10) are independently electrically connected to the safety control system (16), wherein the safety control systems (16) shuts down the working means, if the magnitude of a voltage at the first and/or second output terminal (12, 14) falls below a predetermined threshold.

10. A method for operating an Output Signal Switching Device (OSSD) (10), the Output Signal Switching Device (10) having at least one pair of electric output terminals, the pair of electric output terminals comprising a first output terminal (12) and a second output terminal (14), the method comprising the steps whereby :
- a first voltage is provided by first voltage reducing means (20) of the Output Signal Switching Device (10) which is lower in magnitude than a supply voltage (18),
- a second voltage is provided by second voltage reducing means (22) of the Output Signal Switching Device (10) which is lower in magnitude than the first voltage,
**characterized in that**
- the second voltage is applied to the first output terminal (12) and
- the first voltage is applied to the second output terminal (14),
wherein
- the second voltage is separated from the first output terminal (12) and/or the first voltage is separated from the second output terminal (14) by switching means (28, 30), if the magnitude of the voltage at the second output terminal (14) is equal to or higher than the magnitude of the supply voltage (18) and/or if the magnitude of the voltage at the first output terminal (12) is equal to or higher than the magnitude of the first voltage.

## Patentansprüche

1. Ausgangsignal-Schaltvorrichtung (OSSD) (10), die aufweist
- mindestens ein Paar elektrische Ausgangsanschlüsse, wobei das Paar elektrischer Ausgangsanschlüsse einen ersten Ausgangsanschluss (12) und einen zweiten Ausgangsanschluss (14) umfasst,
- ein erstes Spannungsreduktionsmittel (20), das eine erste Spannung bereitstellt, deren Amplitude kleiner als diejenige der Versorgungsspannung (18) ist,
- ein zweites Spannungsreduktionsmittel (22), das eine zweite Spannung bereitstellt, deren Amplitude kleiner als diejenige der ersten Spannung ist, **dadurch gekennzeichnet, dass**
die zweite Spannung an dem ersten Ausgangsanschluss (12) anliegt und die erste Spannung an den zweiten Ausgangsanschluss (14) anliegt,
wobei
Schaltmittel (28, 30) bereitgestellt sind, die angepasst sind
um die zweite Spannung von dem ersten Ausgangsanschluss (12) und/oder die erste Spannung von dem zweiten Ausgangsanschluss (14) zu trennen, wenn die Amplitude der Spannung an dem zweiten Ausgangsanschluss (14) größer oder gleich der Amplitude der Versorgungsspannung (18) ist, und/oder wenn die Amplitude der Spannung an dem ersten Ausgangsanschluss (12) größer oder gleich der Amplitude der ersten Spannung ist.

2. Vorrichtung (10) nach Anspruch 1, wobei
die Schaltmittel (28, 30) angepasst sind
um die zweite Spannung von dem ersten Ausgangsanschluss (12) zu trennen, wenn die Amplitude der Spannung an dem zweiten Ausgangsanschluss (14) größer oder gleich der Amplitude der Versorgungsspannung (18) ist, und
um die erste Spannung von dem zweiten Ausgangsanschluss (14) zu trennen, wenn die Amplitude der Spannung an dem ersten Ausgangsanschluss (12) größer oder gleich der Amplitude der ersten Spannung ist.

3. Vorrichtung (10) nach Anspruch 1 oder 2, wobei
die Schaltmittel umfassen
einen ersten Unterbrechungsschalter (28), der angepasst ist, um die zweite Spannung von dem ersten Ausgangsanschluss (12) abzuklemmen, wenn die Amplitude der Spannung an dem zweiten Ausgangsanschluss (14) größer oder gleich der Amplitude der Versorgungsspannung (18) ist und/oder
einen zweiten Unterbrechungsschalter (30), der angepasst ist, um die erste Spannung von dem zweiten Ausgangsanschluss (14) abzuklemmen, wenn die Amplitude der Spannung an dem ersten Ausgangsanschluss (12) größer oder gleich der Amplitude der ersten Spannung ist.

4. Vorrichtung (10) nach Anspruch 3, wobei
der erste Unterbrechungsschalter (28) durch erste Vergleichsmittel (32) gesteuert wird, welche vorzugsweise angepasst sind, um ein erstes Steuerungssignal für den ersten Unterbrechungsschalter (28) bereitzustellen, wobei das erste Steuerungssignal auf inaktiv geschaltet wird, wenn der erste Unterbrechungsschalter die zweite Spannung von dem ersten Ausgangsanschluss (12) abklemmen soll, und/oder
der zweite Unterbrechungsschalter (30) durch zweite Vergleichsmittel (34) gesteuert wird, welche vorzugsweise angepasst sind, um ein zweites Steuerungssignal für den zweiten Unterbrechungsschalter (30) bereitzustellen, wobei das zweite Steuerungssignal auf inaktiv geschaltet wird, wenn der zweite Unterbrechungsschalter (30) die zweite Spannung von dem ersten Ausgangsanschluss abklemmen soll.

5. Vorrichtung (10) nach Anspruch 4, wobei
die ersten Vergleichsmittel einen ersten PNP-Transistor (28) umfassen, wobei der Emitter des ersten PNP-Transistors (28) mit der Versorgungsspannung verbunden ist und die Basis des ersten PNP-Transistors (28) mit dem zweiten Ausgangsanschluss (14) verbunden ist, und/oder
die zweiten Vergleichsmittel einen zweiten PNP-Transistor (30) umfassen, wobei der Emitter des zweiten PNP-Transistors (30) mit der ersten Spannung verbunden ist und die Basis des zweiten PNP-Transistors (30) mit dem ersten Ausgangsanschluss (12) verbunden ist.

6. Vorrichtung (10) nach einem der Ansprüche 3 bis 5, ferner umfassend
einen ersten High-Side-Schalter (24), der zwischen dem ersten Spannungsreduktionsmittel (20) und dem ersten Unterbrechungsschalter (28) in Reihe verbunden ist, und/oder
einen zweiten High-Side-Schalter (26), der zwischen dem zweiten Spannungsreduktionsmittel (22) und dem zweiten Unterbrechungsschalter (30) in Reihe verbunden ist.

7. Vorrichtung (10) nach mindestens Anspruch 4 und 6, ferner umfassend einen Controller (44), der angepasst ist
um das erste Steuerungssignal und/oder das zweite Steuerungssignal zu empfangen und
um die Spannung an dem ersten Ausgangsanschluss (12) und/oder an dem zweiten Ausgangsanschluss (14) zu überwachen,
wobei der Controller (44) ausgestaltet ist, um den ersten und/oder den zweiten High-Side-Schalter (24, 26) auszuschalten, wenn die Amplitude der Spannung an dem zweiten Ausgangsanschluss (14) größer oder gleich der Amplitude der Versorgungsspannung (18) ist, und/oder wenn die Amplitude der Spannung an dem ersten Ausgangsanschluss (12) größer oder gleich der Amplitude der ersten Spannung ist.

8. Vorrichtung (10) nach einem der vorstehenden Ansprüche, ferner umfassend
mindestens einen Sicherheitssensor, beispielsweise einen magnetischen Türsensor, wobei die Vorrichtung (10) ausgestaltet ist, um die zweite Spannung von dem ersten Ausgangsanschluss (12) und/oder die erste Spannung von dem zweiten Ausgangsanschluss (14) zu trennen, wenn eine Aktivierung des Sicherheitssensors detektiert wird.

9. Maschine, die mindestens eine Ausgangssignal-Schaltvorrichtung (10) in Übereinstimmung mit einem der vorstehenden Ansprüche, ein Sicherheitssteuerungssystem (16) und Arbeitsmittel umfasst, wobei
der erste Ausgangsanschluss (12) und der zweite Ausgangsanschluss (14) der Ausgangssignal-Schaltvorrichtung (10) elektrisch voneinander unabhängig mit dem Sicherheitssteuerungssystem (16) verbunden sind, wobei das Sicherheitssteuerungssystem (16) die Arbeitsmittel ausschaltet, wenn die Amplitude einer Spannung an dem ersten und/oder zweiten Ausgangsanschluss (12, 14) unter einen vorbestimmten Schwellenwert fällt.

10. Verfahren zum Betreiben einer Ausgangssignal-Schaltvorrichtung (OSSD) (10), wobei die Ausgangssignal-Schaltvorrichtung (10) mindestens ein Paar elektrischer Ausgangsanschlüsse aufweist, wobei das Paar elektrischer Ausgangsanschlüsse einen ersten Ausgangsanschluss (12) und einen zweiten Ausgangsanschluss (14) umfasst,
wobei das Verfahren die Schritte umfasst, dass:
- eine erste Spannung durch ein erstes Spannungsreduktionsmittel (20) der Ausgangssignal-Schaltvorrichtung (10) bereitgestellt wird, deren Amplitude kleiner als diejenige einer Versorgungsspannung (18) ist,
- eine zweite Spannung durch ein zweites Spannungsreduktionsmittel (22) der Ausgangssignal-Schaltvorrichtung (10) bereitgestellt wird, deren Amplitude kleiner als diejenige der ersten Spannung ist,
**dadurch gekennzeichnet, dass**
- die zweite Spannung an den ersten Ausgangsanschluss (1) angelegt wird, und
- die erste Spannung an den zweiten Ausgangsanschluss (14) angelegt wird, wobei
- durch Schaltmittel (28, 30) die zweite Spannung von dem ersten Ausgangsanschluss (12) getrennt wird und/oder die erste Spannung von dem zweiten Ausgangsanschluss (14) getrennt wird, wenn die Amplitude der Spannung an dem zweiten Ausgangsanschluss (14) größer oder gleich der Amplitude der Versorgungsspannung (18) ist, und/oder wenn die Amplitude der Spannung an dem ersten Ausgangsanschluss (12) größer oder gleich der Amplitude der ersten Spannung ist.

## Revendications

1. Dispositif de commutation de signal de sortie (OSSD) (10) présentant
- au moins une paire de bornes électriques de sortie, la paire de bornes électriques de sortie comprenant une première borne de sortie (12) et une deuxième borne de sortie (14),
- un premier moyen de réduction de tension (20) fournissant une première tension dont l'amplitude est inférieure à celle de la tension d'alimentation (18),
- un deuxième moyen de réduction de tension (22) fournissant une deuxième tension dont l'amplitude est inférieure à celle de la première tension, **caractérisé en ce que**
la deuxième tension est appliquée à la première borne de sortie (12) et
la première tension est appliquée à la deuxième borne de sortie (14),
dans lequel
des moyens de commutation (28, 30) sont prévus, qui sont adaptés
à séparer la deuxième tension de la première borne de sortie (12) et/ou la première tension de la deuxième borne de sortie (14) si l'amplitude de la tension à la deuxième borne de sortie (14) est égale ou supérieure à l'amplitude de la tension d'alimentation (18) et/ou si l'amplitude de la tension à la première borne de sortie (12) est égale ou supérieure à l'amplitude de la première tension.

2. Dispositif (10) selon la revendication 1, dans lequel
les moyens de commutation (28, 30) sont adaptés
à séparer la deuxième tension de la première borne de sortie (12) si l'amplitude de la tension à la deuxième borne de sortie (14) est égale ou supérieure à l'amplitude de la tension d'alimentation (18) et
à séparer la première tension de la deuxième borne de sortie (14) si l'amplitude de la tension à la première borne de sortie (12) est supérieure ou égale à l'amplitude de la première tension.

3. Dispositif (10) selon la revendication 1 ou 2, dans lequel
les moyens de commutation comprennent
un premier commutateur de coupure (28) adapté à déconnecter la deuxième tension de la première borne de sortie (12) si l'amplitude de la tension à la deuxième borne de sortie (14) est égale ou supérieure à l'amplitude de la tension d'alimentation (18) et/ou
un deuxième commutateur de coupure (30) adapté à déconnecter la première tension de la deuxième borne de sortie (14) si l'amplitude de la tension à la première borne de sortie (12) est supérieure ou égale à l'amplitude de la première tension.

4. Dispositif (10) selon la revendication 3, dans lequel
le premier commutateur de coupure (28) est commandé par un premier moyen de comparaison (32) qui est de préférence adapté à fournir un premier signal de commande au premier commutateur de coupure (28), le premier signal de commande étant commuté sur inactif si le premier commutateur de coupure doit déconnecter la deuxième tension de la première borne de sortie (12) et/ou
le deuxième commutateur de coupure (30) est commandé par un deuxième moyen de comparaison (34) qui est de préférence adapté à fournir un deuxième signal de commande au deuxième commutateur de coupure (30), le deuxième signal de commande étant commuté sur inactif si le deuxième commutateur de coupure (30) doit déconnecter la deuxième tension de la première borne de sortie.

5. Dispositif (10) selon la revendication 4, dans lequel
le premier moyen de comparaison comprend un premier transistor pnp (28), l'émetteur du premier transistor pnp (28) étant connecté à la tension d'alimentation et la base du premier transistor pnp (28) étant connectée à la deuxième borne de sortie (14) et/ou
le deuxième moyen de comparaison comprend un deuxième transistor pnp (30), l'émetteur du deuxième transistor pnp (30) étant connecté à la première tension et la base du deuxième transistor pnp (30) étant connectée à la première borne de sortie (12).

6. Dispositif (10) selon au moins l'une des revendications 3 à 5, comprenant en outre
un premier commutateur côté haut (24) connecté en série entre le premier moyen de réduction de tension (20) et le premier commutateur de coupure (28) et/ou
un deuxième commutateur côté haut (26) connecté en série entre le deuxième moyen de réduction de tension (22) et le deuxième commutateur de coupure (30).

7. Dispositif (10) selon au moins les revendications 4 et 6, comprenant en outre un dispositif de commande (44) qui est adapté
à recevoir le premier signal de commande et/ou le deuxième signal de commande et
à surveiller la tension à la première borne de sortie (12) et/ou la deuxième borne de sortie (14),
le dispositif de commande (44) étant configuré pour désactiver le premier et/ou le deuxième commutateur côté haut (24, 26) si l'amplitude de la tension à la deuxième borne de sortie (14) est égale ou supérieure à l'amplitude de la tension d'alimentation (18) et/ou si l'amplitude de la tension à la première borne de sortie (12) est égale ou supérieure à l'amplitude de la première tension.

8. Dispositif (10) selon au moins l'une des revendications précédentes, comprenant en outre
au moins un capteur de sécurité, par exemple un capteur de porte magnétique, le dispositif (10) étant configuré pour séparer la deuxième tension de la première borne de sortie (12) et/ou la première tension de la deuxième borne de sortie (14) si une activation du capteur de sécurité est détectée.

9. Machine comprenant au moins un dispositif de commutation de signal de sortie (10) selon au moins l'une des revendications précédentes, un système de commande de sécurité (16) et des moyens de travail, dans laquelle
la première borne de sortie (12) et la deuxième borne de sortie (14) du dispositif de commutation de signal de sortie (10) sont connectées électriquement de manière indépendante au système de commande de sécurité (16), le système de commande de sécurité (16) arrêtant les moyens de travail (16) si l'amplitude d'une tension aux première et/ou deuxième bornes de sortie (12, 14) tombe au-dessous d'un seuil prédéterminé.

10. Procédé de fonctionnement d'un dispositif de commutation de signal de sortie (OSSD) (10), le dispositif de commutation de signal de sortie (10) présentant
au moins une paire de bornes électriques de sortie, la paire de bornes électriques de sortie comprenant une première borne de sortie (12) et une deuxième borne de sortie (14), le procédé comprenant les étapes selon lesquelles :
- une première tension est fournie par un premier moyen de réduction de tension (20) du dispositif de commutation de signal de sortie (10), dont l'amplitude est inférieure à celle d'une tension d'alimentation (18),
- une deuxième tension est fournie par un deuxième moyen de réduction de tension (22) du dispositif de commutation de signal de sortie (10), dont l'amplitude est inférieure à celle la première tension,
**caractérisé en ce que**
- la deuxième tension est appliquée à la première borne de sortie (12) et
- la première tension est appliquée à la deuxième borne de sortie (14),
- la deuxième tension étant séparée de la première borne de sortie (12) et/ou la première tension étant séparée de la deuxième borne de sortie (14) par des moyens de commutation (28, 30) si l'amplitude de la tension à la deuxième borne de sortie (14) est égale ou supérieure à l'amplitude de la tension d'alimentation (18) et/ou si l'amplitude de la tension à la première borne de sortie (12) est supérieure ou égale à l'amplitude de la première tension.
